# EUROPEAN PATENT APPLICATION

(11) **EP 0 574 206 A2**
(43) Date of publication of application: **15.12.1993**
(21) Application number: 93304381.2
(22) Date of filing: 04.06.1993
(51) Int. Cl.: H05K 3/46, H05K 1/18, H05K 1/16, H05K 1/00

(54) **Multilayer printed circuit board and method for manufacturing the same**

(30) Priority: 08.06.1992 JP 173797/92
(71) Applicant: Nippon CMK Corp., Iruma-Gun Saitama (JP)
(72) Inventor: Matsumoto, Masuo, Iruma-gun, Saitama (JP); Birukawa, Fusao, Iruma-gun, Saitama (JP); Takahashi, Takazo, Iruma-gun, Saitama (JP); Shirai, Junzaburo, Iruma-gun, Saitama (JP); Kojima, Mikiya, Iruma-gun, Saitama (JP)
(74) Representative: Boydell, John Christopher

(57) **Abstract**

[Object] To provide a printed circuit board having electronic component functions buried in a substrate laminate.

[Constitution] Holes of an inner substrate 2 are filled with a dielectric paste 6 and a resistor paste 7. These pastes are sealed with a plating layer 13. Thus, the functions of a capacitor and a resistor are buried in the inner substrate 2. Outer substrates 2, 3 are laminated to the inner substrate 2, and holes of the outer substrates 2, 3 are filled with a dielectric paste 6a and a resistor paste 7a, followed by sealing of these pastes with a plating layer 17. Thus, the functions of a capacitor and a resistor are buried in the outer substrates 2, 3. Therefore, the multilayer printed circuit board of the present invention has electronic component functions buried therein.

## Description

The present invention relates to a multilayer printed circuit board and a method for manufacturing the same. More particularly, the present invention is concerned with a multilayer printed circuit board having holes filled with a dielectric paste and a resistor paste so that the board has electronic component functions buried therein, and also concerned with a method for manufacturing such a multilayer printed circuit board.

### Discussion of Related Art

The multilayer printed circuit board comprises a plurality of printed circuit substrates laminated to each other. In the multilayer printed circuit board, there are multiple conductor layers, e.g., four, six or eight conductor layers, so that a high integration of circuits can be realized. Generally, electronic components are mounted on the multilayer printed circuit board by soldering them at lands formed on the front and back sides of the board.

However, the mounting of electronic components on the front and back sides of the multilayer printed circuit board has a limitation in the area on which the electronic components can be mounted. Accordingly, for increasing the volume of electronic components mounted on the board, it is necessary to employ a large multilayer printed circuit board. However, the size of the multilayer printed circuit board is governed by the final electronic apparatus, so that the increase of the size of the multilayer printed circuit board is limited to thereby cause the volume of mounted electronic components to be unsatisfactorily small. Therefore, efforts are being made to miniaturize electronic components for use on a multilayer printed circuit board so as to attain an increase in packaging density. Actually, very small chips have been developed as a resistor and a capacitor. In the mounting of miniaturized miniaturized electronic components, high precision mounting technology and high precision reflow soldering technique are inevitably required. Therefore, the miniaturization of electronic components has been accompanied by a problem that the mounting of electronic components is generally difficult.

### Summary of The Invention

In the above situation of the art, the present inventors have made extensive and intensive studies for attaining an increased incorporation of electronic component functions in a multilayer printed circuit board. As a result, they have unexpectedly found that the increased incorporation of electronic components can be attained by the burial of dielectric and resistor pastes in the multilayer printed circuit board. Based on this novel finding, the present invention has been completed.

It is, therefore, an object of the present invention to provide a multilayer printed circuit board in which a large amount of electronic component functions can be incorporated, irrespective of the mounting of electronic components to the outer surfaces of the board.

It is another object of the present invention to provide a method for effectively manufacturing such a multilayer printed circuit board.

The foregoing and other objects, features and advantages of the present invention will become apparent from the following detailed description and appended claims taken in connection with the accompanying drawings.

### Brief Description of The Drawings

In the drawings:
Fig. 1 is a block diagram illustrating the steps of a method for manufacturing a multilayer printed circuit board according to one embodiment of the present invention;
Fig. 2 is a sectional view of an inner substrate for use in the multilayer printed circuit board of the present invention;
Fig. 3 is a sectional view of an inner substrate processed for the incorporation of electronic component functions in the inner substrate;
Fig. 4 is a sectional view of an inner substrate further processed for the incorporation of electronic component functions in the inner substrate;
Fig. 5 is a sectional view of an inner substrate still further processed for the incorporation of electronic component functions in the inner substrate;
Fig. 6 is a sectional view of an inner substrate still further processed for the incorporation of electronic component functions in the inner substrate;
Fig. 7 is a sectional view of an inner substrate still further processed for the incorporation of electronic component functions in the inner substrate;
Fig. 8 is a sectional view showing a section of each of an inner substrate and outer substrates provided for lamination to each other;
Fig. 9 is a sectional view of a laminate comprised of an inner substrate having outer substrates laminated thereto;
Fig. 10 is a sectional view of a laminate processed for the incorporation of electronic component functions in the outer substrates;
Fig. 11 is a sectional view of a laminate further processed for the incorporation of electronic component functions in the outer substrates;
Fig. 12 is a sectional view of a laminate still further processed for the incorporation of electronic component functions in the outer substrates;
Fig. 13 is a sectional view of a laminate still further processed for the incorporation of electronic component functions in the outer substrates;
Fig. 14 is a view showing a section of a multilayer printed circuit board according to one embodiment of the present invention;
Fig. 15 is a view showing a section of a multilayer printed circuit board according to another embodiment of the present invention;
Fig. 16 is a view showing a section of a portion of a multilayer printed circuit board according to a further embod iment of the present invention; and
Fig. 17 is a sectional view of a portion of a modified form of the multilayer printed circuit board illustrated in Fig. 16.

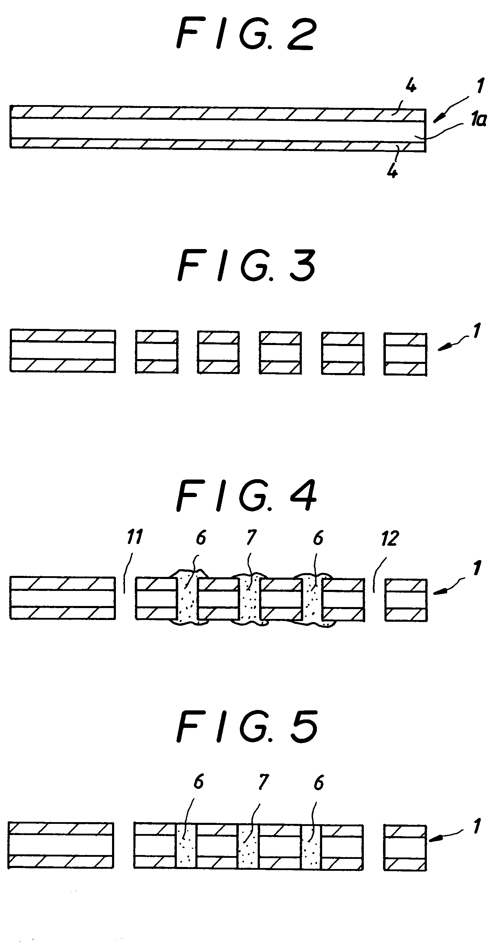

In Figs. 2 through 17, like parts or portions are designated by like numerals.

### Detailed Description of The Invention

In one aspect of the present invention, there is provided a multilayer printed circuit board comprising at least two laminated printed circuit substrates each having holes filled with a paste selected from the group consisting of a resistor paste and a dielectric paste, the paste being sealed with a plating layer.

In another aspect of the present invention, the above multilayer printed circuit board is manufactured by a method comprising the steps of:
providing a preliminary multilayer printed circuit board having holes passing through at least two laminated substrates or passing through at least one substrate,
filling at least a part of the holes with a paste selected from the group consisting of a resistor paste and a dielectric paste, and
sealing the paste with a plating layer.

In a further aspect of the present invention, the desired multilayer printed circuit board is also manufactured by a method comprising the steps of:
providing a first substrate having holes,
filling at least a part of the holes with a paste selected from the group consisting of a resistor paste and a dielectric paste,
sealing the paste with a plating layer,
laminating at least one second substrate to the first substrate,
forming holes in the second substrate,
filling at least a part of the holes of the second substrate and holes present in the first substrate and the second substrate in communicating relationship with a paste selected from the group consisting of a resistor paste and a dielectric paste, and
sealing the paste with a plating layer.

In still a further aspect of the present invention, the desired multilayer printed circuit board is also manufactured by a method comprising the steps of:
providing a first substrate having holes,
filling at least a part of the holes with a paste selected from the group consisting of a resistor paste and a dielectric paste,
sealing the paste with a plating layer,
laminating at least one second substrate to the first substrate, the second substrate having holes previously formed,
filling at least a part of the holes of the second substrate and holes present in the first substrate and the second substrate in communicating relationship with a paste selected from the group consisting of a resistor paste and a dielectric paste, and
sealing the paste with a plating layer.

In addition, in still a further aspect of the present invention, the desired multilayer printed circuit board may also be manufactured by a method comprising the steps of:
providing a laminate of at least two substrates each having a conductor layer,
removing the conductor layer from at least one of the substrates to form empty portions,
filling the empty portions with a paste selected from the group consisting of a resistor paste and a dielectric paste,
sealing the paste with a plating layer, and
partially removing the plating layer present on the paste.

The multilayer printed circuit board structured as described above exhibits the same functions as exhibited by a resistor disposed in the board by virtue of the filling of the resistor paste in holes of the board, and exhibits the same functions as exhibited by a capacitor disposed in the board by virtue of the filling of the dielectric paste in holes of the board. Thus, by the filling of the resistor paste and the dielectric paste in holes of the board, the number of resistors and capacitors to be mounted on the outer surfaces of the board can be decreased, so that the board has on its outer surfaces an increased space for permitting the mounting of electronic components.

The multilayer printed circuit board structured as described above can be effectively manufactured by the above described methods in which essentially the holes passing through at least two laminated substrates or passing through at least one substrate are filled with a paste selected from the group consisting of a resistor paste and a dielectric paste, followed by sealing with a plating layer.

### Preferred Embodiment of The Invention

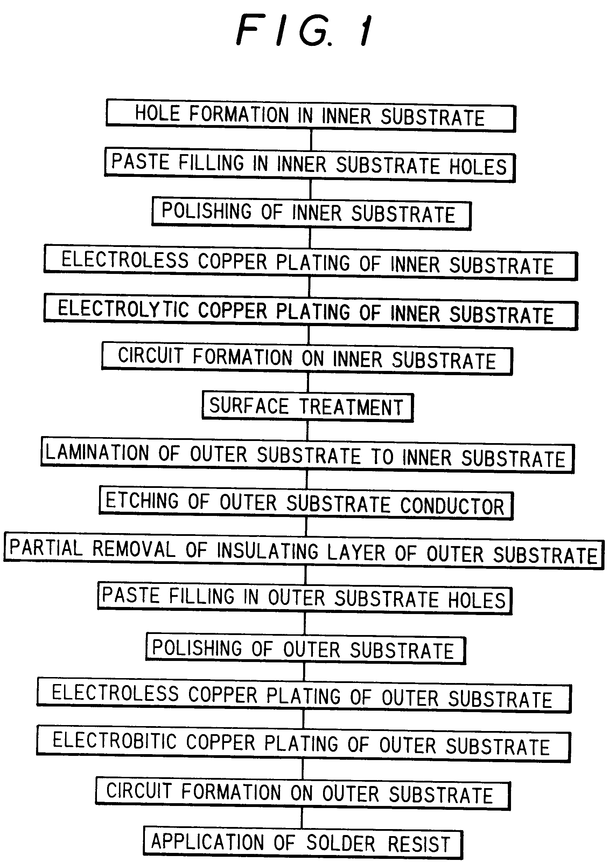

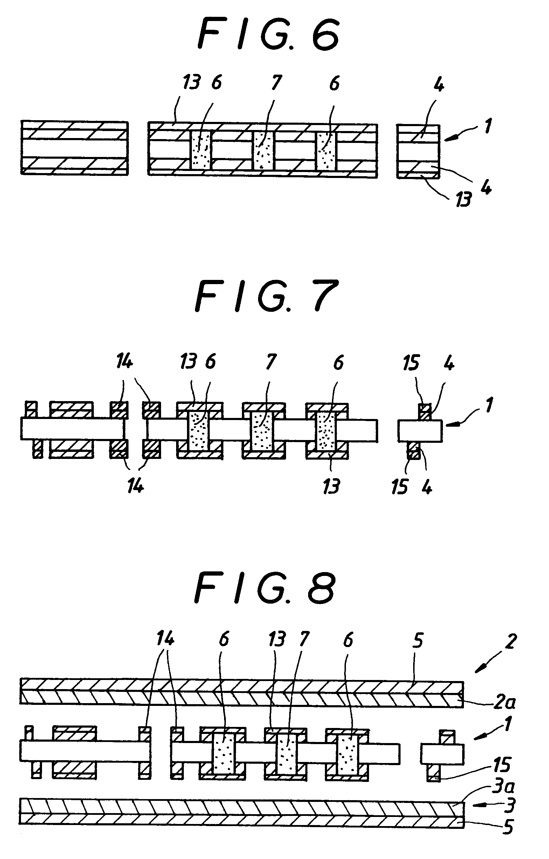

Hereinbelow, the present invention will be described in greater detail with reference to the following Examples as illustrated in the appended drawings. Fig. 1 shows a sequence of steps to be taken in the manufacturing method according to one embodiment of the present invention. Figs. 2 to 14 show sectional views of respective articles produced in the steps. In this Example, a four-layer printed circuit board is described, comprising an inner substrate 1 and, laminated to an upper surface and a lower surface of the inner substrate 1, two outer substrates 2, 3. In the four-layer printed circuit board, a first circuit conductor is formed on the upper surface of the upper outer substrate 2, a second circuit conductor formed on the upper surface of the inner substrate 1, a third circuit conductor formed on the lower surface of the inner substrate 1 and a fourth circuit conductor formed on the lower surface of the lower outer substrate 3. The inner substrate 1 comprises an insulating layer 1a clad on both sides thereof with copper foils 4. The upper and lower outer substrates 2, 3 respectively comprise insulating layers 2a, 3a which are, on one side thereof, clad with copper foils 5, respectively (see Fig. 8). These substrates are laminated to each other for example, through an adhesive sheet (not shown) impregnated with an epoxy resin, a polyimide resin or the like.

First, as illustrated in Figs. 2 and 3, the inner substrate 1 is drilled or punched to form a plurality of holes. Of the formed plurality of holes, at least a part of holes are filled with a paste selected from the group consisting of a resistor paste, a dielectric paste and a conductor paste. In Fig. 4, numeral 6 designates a dielectric paste, and numeral 7 designates a resistor paste. Numeral 11 designates a connection hole for forming a through-hole, and numeral 12 designates a non-through-hole through which no electric connection is performed. The filling of the pastes 6, 7 is performed in an amount such that the pastes 6, 7 overflow respective holes of the inner substrate 1. After the filling, the pastes 6, 7 are polished so that the inner substrate 1 and the pastes 6, 7 have a common flat surface as illustrated in Fig. 5. The resultant inner substrate 1 is subjected to electroless copper plating and then to electrolytic copper plating. As a result, the inner substrate 1 has a plating layer 13 on both sides thereof, so that the resistor paste 7 and the dielectric paste 6 are sealed in the inner substrate 1, as shown in Fig. 6.

The plating layer 13 mentioned above and the respective copper foils 4 on both sides of the insulating layer 1a are subjected to a treatment comprising application of a photosensitive resin, light exposure and etching to form lands 14 and circuits 15 on both sides of the inner substrate 1, as illustrated in Fig. 7. At this treatment, portions of the plating layer corresponding to the pastes 6, 7 are kept unremoved so that the pastes 6, 7 remain sealed in the inner substrate 1. By virtue of the sealing of the resistor paste 7 and the dielectric paste 6 in the inner substrate 1 with the plating layer 13, the pastes 6, 7 can communicate with the exterior (in this Example, the outer substrate). Accordingly, the portion having the resistor paste 7 sealed therein exhibits the functions equivalent to those of a resistor, and the portion having the dielectric paste 6 sealed therein exhibits the functions equivalent to those of a capacitor. Hence, the same situation is generated as when a resistor chip and a capacitor chip have been mounted on the inner substrate 1. The resistance of the resistor paste 7 and the capacitance of the dielectric paste 6 are set so as to assume desired values, and accordingly, the resistivity of the resistor paste 7, the size of the hole in which the resistor paste 7 is filled, the dielectric constant of the dielectric paste 6 and the size of the hole in which the dielectric paste 6 is filled, are selected in accordance with the above desired values.

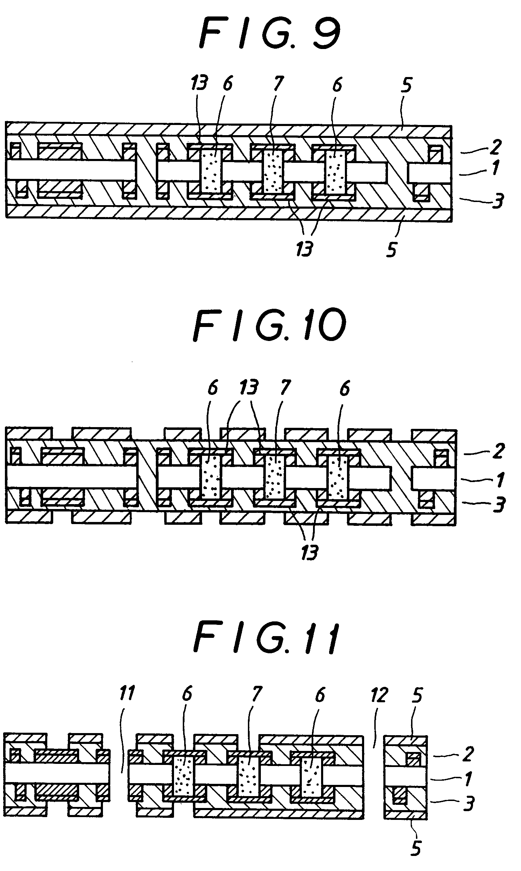

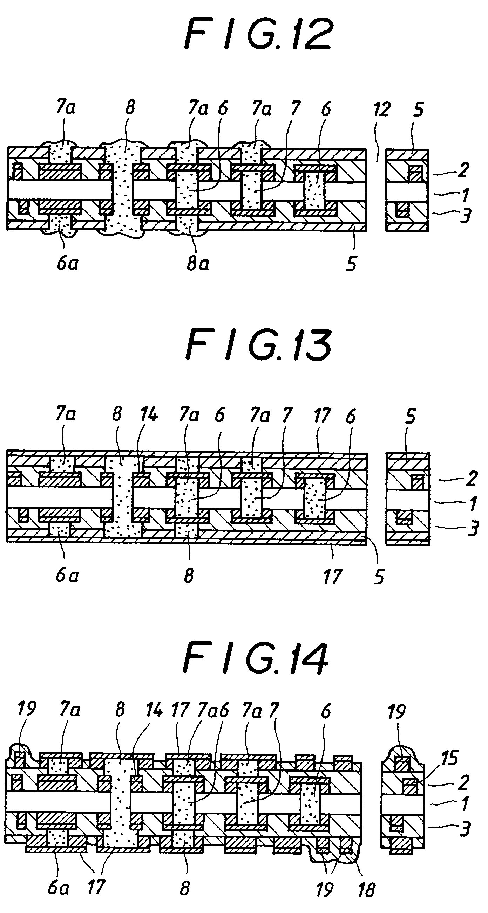

Subsequently, the upper and lower surfaces of the resultant inner substrate 1 are subjected to surface treatment, such as melanin blacking, and outer substrates 2, 3 are laminated to the surface treated upper and lower surfaces, respectively, of the inner substrate by pressing or roll lamination. Fig. 8 illustrates an arrangement of the inner and outer substrates prior to the lamination, and Fig. 9 illustrates an arrangement of the inner and outer substrates after the lamination. Since overflowed portions of the pastes 6, 7 of the inner substrate 1 are polished off to obtain a common flat surface, the adhesion of the outer substrates 2, 3 to the inner substrate 1 is excellent. After the lamination, as illustrated in Fig. 10, the copper foils 5 of the upper and lower outer substrates 2, 3 are subjected to etching treatment to thereby remove portions of the copper foils 5. Thereafter, portions of the insulating layers 2a, 3a of the outer substrates 2, 3 corresponding to portions of the copper foils 5 removed by the above etching treatment are removed by physical or chemical means or by laser irradiation. As a result, as illustrated in Fig. 11, holes extending to the inner substrate 1 are formed in the outer substrates 2, 3.

Fig. 12 is a sectional view illustrating the filling of a paste in holes formed in the outer substrates 2, 3. In Fig. 12, numeral 6a designates a newly inserted dielectric paste, numeral 7a designates a newly inserted resistor paste, and numeral 8 designates a conductor paste, such as a silver paste and a copper paste. The filling of the pastes 6a, 7a, 8 is performed in an amount such that the pastes 6a, 7a, 8 overflow respective holes of the outer substrates 2, 3. After the filling, overflowed portions of the pastes 6a, 7a, 8 are polished off so that the outer substrates 2, 3 and the pastes 6a, 7a, 8 have common flat surfaces.

Both sides of the thus obtained laminate are subjected to electroless copper plating and then to electrolytic copper plating to thereby have both of the sides clad with plating layers 17 (see Fig. 13). After the clothing of the plating layers 17, the plating layers 17 and the copper foils 5 on the outer substrates 2, 3 are subjected to a treatment comprising application of a photosensitive resin, light exposure and etching to form lands and circuits on both the sides of the laminate. At this treatment, portions of the plating layer corresponding to the pastes 6a, 7a, 8 are unremoved so that the pastes 6a, 7a, 8 remain sealed in the laminate. In Fig. 14, numeral 18 designates a solder resist for protecting circuits 19 formed on both the sides of the laminate.

As a result of the sealing of the pastes 6a, 7a, 8 with the plating layers 17, the resistor and capacitor functions are housed in the laminate, and the inner substrate 1 and the outer substrates 2, 3 are mutually electrically connected. Illustratively stated, the resistor paste 7a shown on the left side of Fig. 14 exhibits the functions equivalent to those of a resistor by being sealed in the upper outer substrate 2. The dielectric paste 6a sealed in the left side of the lower outer substrate 3 exhibits the functions equivalent to those of a capacitor. At about the middle of the multilayer printed circuit board, not only the resistor paste 7a is sealed in the upper outer substrate 2 via the plating layer, as a conductor, on the dielectric paste 6 sealed in the inner substrate 1, but also the conductor paste 8 is sealed in the lower outer substrate 3 via the plating layer under the dielectric paste 6 sealed in the inner substrate 1. Hence, at the middle thereof, the multilayer printed circuit board contains the functions equivalent to those of an electric circuit comprising a resistor, a capacitor and a wire arranged in series. Further, the resistor paste 7a is sealed in the upper outer substrate 2 on the resistor paste 7 sealed in the inner substrate 1, and the resistor paste 7a and the resistor paste 7 are electrically connected with each other via the plating layer clothing the inner substrate 1. Hence, at this region, the multilayer printed circuit board contains the functions equivalent to those of an electric circuit comprising resistors arranged in series.

In this Example, due to the burial of the functions equivalent to those of electronic components, such as a resistor and a capacitor, the multilayer printed circuit board can exhibit the same functions as exhibited when such electronic components have been mounted on the outer surfaces of the board. Hence, the number of electronic components to be mounted on the outer surfaces of the board can be reduced to thereby increase the space for lands and circuits to be formed on the board. Thus, the outer surfaces of the multilayer printed circuit board can be effectively utilized. Further, the pastes are sealed with a plating layer, so that desirable, highly reliable electric connection is attained to ensure the connection suitable for desired functions, even when the holes have a small size. Still further, in this Example, the paste sealed in the inner substrate can be electrically connected with the paste sealed in the outer substrate via the plating layer, so that an electric circuit equivalent to one having a plurality of electronic components connected thereto can be buried in the board. As a result, it becomes unnecessary to individually mount electronic components on the outer surfaces of the board in a manner such that they are mutually connected, so that cumbersome surface mounting of electronic components can be avoided. Moreover, the pastes can sequentially be built up via the plating layer, and consequently, electric circuits can sequentially be formed in the laminated substrate board even when the number of laminated substrates is large. Therefore, in the multilayer printed circuit board of the present invention, very complex circuits can be buried. When the circuit or land present on the paste is very small, it may occur that the paste is exposed between circuits or lands. In such a case, a protective coating is applied to protect the paste.

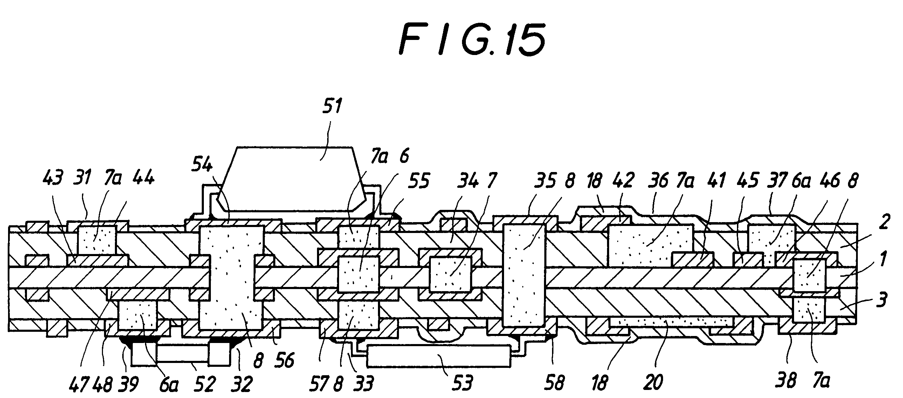

Fig. 15 illustrates another embodiment of the present invention, and employs the same numeral for designating the same part or portion as in the foregoing embodiment. In this Example as well, holes of the inner substrate 1, holes of the outer substrates 2, 3 and holes present in these substrates in communicating relationship are filled with the dielectric pastes 6, 6a, the resistor pastes 7, 7a and the conductor paste 8. These pastes are sealed with the plating layer. Details are as follows. Numeral 31 designates a connection of a land 43 of the inner substrate 1 and a land 44 of the outer substrate 2 by the insertion of the resistor paste 7a in a hole of the upper outer substrate 2. Numeral 32 designates a through-hole filled with the conductor paste 8 for electrically connecting respective lands of the upper and lower outer substrates 2, 3 and the inner substrate 1. Numeral 33 designates an electric circuit structured to have a resistor and a wire connected to each other, in which the dielectric paste 6 is sealed in the inner substrate 1, the resistor paste 7a is sealed in the upper outer substrate 2 and the conductor paste 8 is sealed in the lower outer substrate 3. Numeral 34 designates a resistor comprised of the resistor paste 7 sealed in the inner substrate 1. Numeral 35 designates a through-hole in which the conductor paste is sealed for connecting lands of the upper and lower outer substrates 2, 3. Numeral 36 designates a resistor comprised of the resistor paste 7a sealed in the upper outer substrate 2 for connecting a land 41 of the inner substrate 1 and a land 42 of the outer substrate 2. Numeral 37 designates a capacitor comprised of the dielectric paste 6a sealed in a hole of the upper outer substrate 2 for mutually connecting lands 45, 46 of the inner substrate 1. Numeral 38 designates an electric circuit comprising a wire and a resistor connected in series between the inner substrate 1 and the lower outer substrate 3, in which the conductor paste 8 is sealed in the inner substrate 1 and the resistor paste 7a is sealed in the lower outer substrate 3. Numeral 39 designates a capacitor comprised of the dielectric paste 6a sealed in the lower outer substrate 3 for connecting a land 47 of the inner substrate 1 and a land 48 of the outer substrate 3. Due to the above burial of a resistor, a capacitor and an electric circuit 4 in the substrate laminate, the number of electronic components to be mounted on the outer surfaces of the laminate can be reduced, and hence, mounting operation of electronic components can be facilitated.

In addition, in this Example, the multilayer printed circuit board includes electronic components, such as an IC 51, a chip resistor 52 and an LSI 53. The IC 51 is mounted with its leads soldered to a land 54 of the upper outer substrate 2 at the through-hole 32 and to a land 55 of the electric circuit 33. The chip resistor 52 is mounted by soldering to a land 48 of the capacitor 39 and to a land 56 of the lower outer substrate 3 at the through-hole 32. The LSI is mounted with its lead soldered between a land 57 of the lower outer substrate 3 of the electric circuit 33 and a land 58 on the lower side of the through-hole 35. The lands 54, 55, 56, 57, 58 at which such electronic components are mounted on the outer surfaces of the laminate are prepared using the plating layer applied to seal the paste. Conventionally, the holes filled with the paste could not be used as a land for mounting electronic components. By contrast, in this Example, the paste is sealed with the plating layer, and this plating layer is utilized as the land or a portion of the land. This is advantageous from the viewpoint of increased packaging density. The plating layer is useful not only as the land for mounting electronic components but also as a portion of the circuit. This further contributes toward an increase in packaging density.

In Fig. 15, numeral 20 designates a resistor formed on the outer surface of the lower outer substrate 3. This resistor 20 is formed by applying the resistor paste onto the outer substrate 3. This attests to the formation of electronic components not only in holes of the substrate but also on the surface of the substrate. The resistor 20 can be protected by the application of a solder resist thereto.

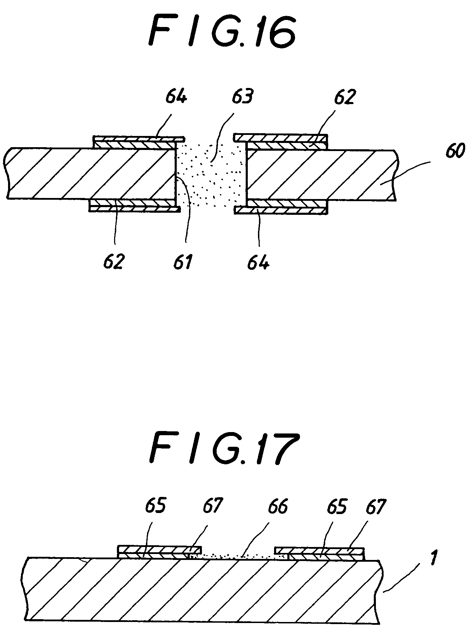

Fig. 16 illustrates a further embodiment of the present invention. Numeral 60 designates a substrate as the inner substrate or the outer substrate. At a predetermined position, a hole 61 is formed. Around the hole 61, a land 62 comprised of a conductor layer is formed. The hole 61 is filled with a paste 63 selected from the group consisting of the resistor paste and the dielectric paste. The paste 63 is clad with a plating layer 64 according to the same procedure as above to thereby seal the paste 63. In this particular Example, the plating layer is partially removed after the sealing. Despite the partial removal of the plating layer 64, the paste 63 can be electrically connected with the plating layer 64, so that the paste 63 can function as a resistor or a capacitor.

Fig. 17 illustrates a modification of the above Example. As a substrate, use is made of the inner substrate 1, to which an outer substrate is laminated. The inner substrate 1 has a copper foil as a conductor layer, which is subjected to etching treatment to form a pair of circuits 65. Numeral 66 designates a paste selected from the group consisting of a resistor paste and a dielectric paste, which is inserted in a copper foil-removed portion by printing, etc. After the insertion of the paste 66, clothing with a plating layer 67 is performed to seal the paste 66. After the sealing, the plating layer 67 is partially removed. As a result of the partial removal of the plating layer 67, the pair of circuits 65 are electrically connected via the paste 66, so that the functions equivalent to those of a resistor or a capacitor is disposed on the inner substrate 1. Lamination of an outer substrate to the inner substrate 1 after the above processing of the inner substrate 1 results in exhibition of the same functions as exhibited when a resistor or a capacitor has been buried in the substrate laminate.

In the above Examples, hole formation in the outer substrate is performed after its lamination to the inner substrate. However, in the present invention, hole formation in the outer substrate may precede its lamination to the inner substrate. In this case, if desired, hole formation in the outer substrate is performed so as to allow formed holes to communicate with the corresponding holes of the inner substrate, and the lamination of the outer substrate to the inner substrate is performed while aligning the positions of the holes so that through-holes passing through the inner and outer substrates are formed.

In the above Examples, the multilayer printed circuit board has had four conductor layers. However, the present invention is not limited to the four conductor layers. The multilayer printed circuit board of the present invention may comprise two laminated substrates having two or three conductor layers, or may comprise at least four laminated substrates having multiple conductor layers. In the case of the former multilayer printed circuit board, the first and the second substrates are laminated to each other and holes are formed passing through both of the substrates or passing through either of the substrates according to the same procedure as above. Then, such holes are filled with selected pastes, and the pastes are polished off, followed by plating treatment to seal the pastes, thereby obtaining the multilayer printed circuit board.

As described above, in the present invention, holes of the laminated substrate are filled with the resistor paste or the capacitor paste, and these pastes are sealed with a plating layer. Thus, the multilayer printed circuit board of the present invention has the functions equivalent to those of electronic components buried therein. Further, the plating layer sealing the pastes can be utilized as a land or a circuit, so that a high packaging density of electronic components is attained.

## Claims

1. A multilayer printed circuit board comprising at least two laminated printed circuit substrates each having holes filled with a paste selected from the group consisting of a resistor paste and a dielectric paste, said paste being sealed with a plating layer.

2. The multilayer printed circuit board according to claim 1, wherein said plating layer is a portion of a circuit.

3. The multilayer printed circuit board according to claim 1, wherein said plating layer is a land for mounting an electronic component.

4. The multilayer printed circuit board according to claim 1, wherein said plating layer has a portion partially removed.

5. A method for manufacturing a multilayer printed circuit board, comprising the steps of:
providing a preliminary multilayer printed circuit board having holes passing through at least two laminated substrates or passing through at least one substrate,
filling at least a part of said holes with a paste selected from the group consisting of a resistor paste and a dielectric paste, and
sealing said paste with a plating layer.

6. A method for manufacturing a multilayer printed circuit board, comprising the steps of:
providing a first substrate having holes,
filling at least a part of said holes with a paste se lected from the group consisting of a resistor paste and a dielectric paste,
sealing said paste with a plating layer,
laminating at least one second substrate to said first substrate,
forming holes in said second substrate,
filling at least a part of said holes of said second substrate and holes present in said first substrate and said second substrate in communicating relationship with a paste selected from the group consisting of a resistor paste and a dielectric paste, and
sealing said paste with a plating layer.

7. A method for manufacturing a multilayer printed circuit board, comprising the steps of:
providing a first substrate having holes,
filling at least a part of said holes with a paste se lected from the group consisting of a resistor paste and a dielectric paste,
sealing said paste with a plating layer,
laminating at least one second substrate to said first substrate, said second substrate having holes previously formed,
filling at least a part of said holes of said second substrate and holes present in said first substrate and said second substrate in communicating relationship with a paste selected from the group consisting of a resistor paste and a dielectric paste, and
sealing said paste with a plating layer.

8. A method for manufacturing a multilayer printed circuit board, comprising the steps of:
providing a laminate of at least two substrates each having a conductor layer,
removing the conductor layer from at least one of said substrates to form empty portions,
filling said empty portions with a paste selected from the group consisting of a resistor paste and a dielectric paste,
sealing said paste with a plating layer, and
partially removing said plating layer present on said paste.

9. The method according to any one of claims 5 to 8, wherein said paste is polished off prior to said sealing with a plating layer until said substrate and said paste have a common flat surface.

10. The method according to any one of claims 5 to 8, wherein said plating layer is converted to a circuit after said sealing with a plating layer.

11. The method according to any one of claims 5 to 8, wherein at least one electronic component is mounted via said plating layer on the multilayer printed circuit board.
